Europäisches Patentamt

European Patent Office

Office européen des brevets

(11) Veröffentlichungsnummer: **0 263 452 B1**

(12) **EUROPÄISCHE PATENTSCHRIFT**

(45) Veröffentlichungstag der Patentschrift: **04.03.92**

(21) Anmeldenummer: **87114453.1**

(22) Anmeldetag: **03.10.87**

(51) Int. Cl.⁵: **G01R 15/10, G01R 15/02**

(54) **Elektrischer Wandler.**

(30) Priorität: **08.10.86 DE 3634221**

(43) Veröffentlichungstag der Anmeldung:
**13.04.88 Patentblatt 88/15**

(45) Bekanntmachung des Hinweises auf die
Patenterteilung:
**04.03.92 Patentblatt 92/10**

(84) Benannte Vertragsstaaten:
**CH DE FR GB LI NL SE**

(56) Entgegenhaltungen:
**US-A- 4 149 120**
**US-A- 4 492 919**
**US-A- 4 541 065**

(73) Patentinhaber: **Asea Brown Boveri Aktiengesellschaft**
**Kallstadter Strasse 1**
**W-6800 Mannheim-Käfertal(DE)**

(72) Erfinder: **Lutz, Ferdinand, Dr. Dr.-Ing.**
**Fikentscherstrasse 42**
**W-8400 Regensburg(DE)**
Erfinder: **Thies, Bernard, Dr. Dr.-Ing.**
**Dettinger Strasse 10**
**W-8757 Karlstein(DE)**

(74) Vertreter: **Rupprecht, Klaus, Dipl.-Ing. et al**
**c/o BBC Brown Boveri Aktiengesellschaft**
**ZPT Postfach 100351 Kallstadter Strasse 1**
**W-6800 Mannheim 1(DE)**

**Beschreibung**

Die Erfindung bezieht sich auf einen elektrischen Wandler gemäß dem Oberbegriff des Anspruchs 1 sowie auf ein Verfahren zur Einstellung des Wandlers.

Ein solcher elektrischer Wandler ist aus der US-A-4 492 919 bekannt. Dort wird ein Stromwandler beschrieben, bei dem eine Hintereinanderschaltung eines Meßwertumformers, eines Verstärkers und einer elektronischen Fehlerkorrekturschaltung eingesetzt ist. Die Fehlerkorrekturschaltung ist der Fehlerkennlinie des Meßwertumformers angepaßt, indem die den Fehler des Meßwertumformers kennzeichnenden und für ihre Korrektur notwendigen Daten innerhalb der Korrekturschaltung gespeichert sind. Der Wandlerausgang wird vom Ausgang der Fehlerkorrekturschaltung gebildet.

Elektrische Wandler in Schaltanlagen dienen als Spannungswandler zur Messung der Spannung auf einer Leitung oder als Stromwandler zur Messung des in der Leitung fließenden Stromes. Sie werden sowohl für Verrechnungszwecke als auch für Schutzfunktionen benötigt. Insbesondere für Verrechnungszwecke wird von Strom- und Spannungswandlern eine große Genauigkeit gefordert. Für Schutzfunktionen wird bei konventionellen Schutzeinrichtungen eine bestimmte Leistung am Ausgang des Wandlers verlangt, die zur Auslösung von Schutzelementen, wie beispielsweise mechanischen Relais (Schützen), ausreicht.

Die beiden Forderungen der hohen Genauigkeit und der hohen Ausgangsleistung führen zu sehr aufwendigen und teueren Wandlerkonstruktionen. Bei sehr hohen geforderten Ausgangsleistungen entstehen darüber hinaus bei konventionellen Stromwandlern, die auf dem Transformatorprinzip aufbauen, Probleme der räumlichen Anordnung, da hohe Leistungen recht große Eisenquerschnitte verlangen.

Man hat deshalb versucht, anstelle des Transformatorprinzips andere Prinzipien der Messung und Umformung der Meßgröße für Wandler einzusetzen. Bei kapazitiven Spannungswandlern erhält man beispielsweise an der Unterkapazität eine der Meßspannung proportionale Spannung, jedoch ist die an den Sekundärklemmen zur Verfügung stehende Leistung für die meisten Anwendungen zu gering. Aus diesem Grunde muß dem kapazitiven Meßwertumformer ein Leistungsverstärker mit hoher Linearität nachgeschaltet werden. Ein so aufgebauter Wandler ist sehr teuer.

Der Erfindung liegt davon ausgehend die Aufgabe Zugrunde, einen elektrischen Wandler der eingangs genannten Art anzugeben, der mit großer Genauigkeit ein leistungsstarkes, der Meßgröße proportionales Signal abgibt. Die große Genauigkeit des leistungsstarken Ausgangssignals soll durch eine konstruktive Lösung erreicht werden, die weniger aufwendig und weniger kostenintensiv ist als die bekannten konstruktiven Lösungen bei Wandlern. Desweiteren soll ein Verfahren zur Einstellung des elektrischen Wandlers angegeben werden.

Diese Aufgabe wird in Verbindung mit den Merkmalen des Oberbegriffes erfindungsgemäß durch die im Kennzeichen des Anspruchs 1 angegebenen Merkmale gelöst. Die Aufgabe wird bezüglich des Verfahrens durch die im Anspruch 4 angegebenen Merkmale gelöst.

Dabei ist es durch die US-A-4 541 065 und die US-A-4 149 120 an sich bekannt, das Ausgangssignal eines Meßsensors unter Einsatz einer Prüfschaltung zu linearisieren, bzw. Fehler zu kompensieren.

Die mit der Erfindung erzielbaren Vorteile bestehen insbesondere darin, daß ein preiswerter Wandler hoher Güte und großer Ausgangsleistung geschaffen wird, ohne daß für den Meßwertumformer die Forderung nach hoher Genauigkeit (Güte) und hoher Ausgangsleistung besteht, und ohne daß für den Leistungsverstärker eine hohe Linearität erforderlich ist. Der Wandler kann universell sowohl für Verrechnungszwecke als auch für Schutzfunktionen eingesetzt werden.

Vorteilhafte Ausgestaltungen der Erfindung sind in den Unteransprüchen gekennzeichnet.

Die Erfindung wird nachstehend anhand des in den Zeichnungen dargestellten Ausführungsbeispiels erläutert.

Es zeigen:

Fig. 1    den Aufbau des elektrischen Wandlers,

Fig. 2    das Ausgangssignal des Meßwertumformers in Abhängigkeit der eingangsseitig anliegenden Meßgröße,

Fig. 3    das Ausgangssignal des Leistungsverstärkers in Abhängigkeit des eingangsseitig an ihm liegenden Signales,

Fig. 4    das Ausgangssignal der Fehlerkorrekturschaltung 3 in Abhängigkeit des eingangsseitig an ihr liegenden Signales.

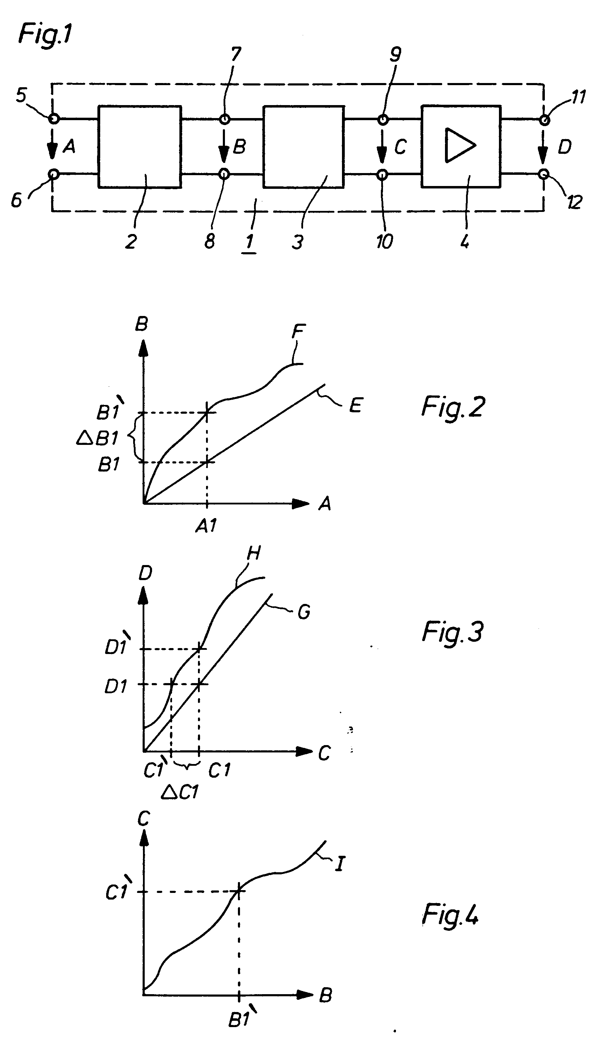

In Fig. 1 ist der Aufbau des elektrischen Wandlers 1 dargestellt. Der Wandler 1 besteht aus einer Hintereinanderschaltung eines Meßwertumformers 2, einer elektronischen Fehlerkorrekturschaltung 3 und eines Leistungsverstärkers 4. Die eingangsseitigen Klemmen des Meßwertumformers 2 sind gleichzeitig die Primärklemmen 5, 6 des elektrischen Wandlers 1. Zwischen ihnen liegt die Meßgröße A als Eingangssignal für den Meßwertumformer 2 an.

Als Meßwertumformer 2 dient beispielsweise ein herkömmlicher Stromwandler oder Spannungswandler. Die Forderung nach hoher Genauigkeit und hoher Ausgangsleistung besteht für den Meßwertumformer 2 nicht.

Das an den Ausgangsklemmen 7, 8 des Meßwertumformers 2 anstehende Ausgangssignal B wird der Fehlerkorrekturschaltung 3 zugeleitet. Die Arbeitsweise der Fehlerkorrekturschaltung 3 wird unter Fig. 4 beschrieben. Das an den Ausgangsklemmen 9, 10 der elektronischen Fehlerkorrekturschaltung 3 abgegebene Ausgangssignal C wird dem Leistungsverstärker 4 zugeführt. Die Ausgangsklemmen des Leistungsverstärkers 4 bilden gleichzeitig die Sekundärklemmen 11, 12 des Wandlers 1, wobei das Ausgangssignal des Wandlers 1 mit D bezeichnet ist. Die Forderung nach hoher Linearität besteht für den Leistungsverstärker 4 nicht.

In Fig. 2 ist das Ausgangssignal B des Meßwertumformers 2 in Abhängigkeit der eingangsseitig anliegenden Meßgröße A dargestellt. Dabei ist mit E die ideale, fehlerfreie Kennlinie und mit F die reale, fehlerbehaftete Kennlinie des Meßwertumformers 2 bezeichnet. Bei Anliegen einer beliebigen Meßgröße A1 an den Primärklemmen 5, 6 gibt der Meßwertumformer 2 ein reales, fehlerbehaftetes Ausgangssignal B1′ (gemäß Kennlinie F) ab. Die Differenz zwischen B1′ und dem idealen, fehlerfreien Ausgangssignal B1 (gemäß Kennlinie E) ist als Korrekturwert Δ B1 bezeichnet. Für unterschiedliche Signale B ergeben sich unterschiedliche Korrekturwerte Δ B. Die Zuordnung zwischen den Signalen B und den zugehörigen Korrekturwerten Δ B ist in der Fehlerkorrekturschaltung 3 abgespeichert.

In Fig. 3 ist das Ausgangssignal des Leistungsverstärkers 4 in Abhängigkeit des eingangsseitig an ihm liegenden Signales dargestellt. Das Ausgangssignal des Leistungsverstärkers 4 entspricht dem Ausgangssignal D des Wandlers 1. Das eingangsseitig am Leistungsverstärker 4 anstehende Signal entspricht dem Ausgangssignal C der Fehlerkorrekturschaltung 3. Dabei ist mit G die ideale, fehlerfreie Kennlinie und mit H die reale, fehlerbehaftete Kennlinie des Leistungsverstärkers 4 bezeichnet. Bei Anliegen eines beliebigen Signales C1 gibt der Leistungsverstärker 4 ein reales, fehlerbehaftetes Ausgangssignal D1′ (gemäß Kennlinie H) ab. Als ideales, fehlerfreies Ausgangssignal (gemäß Kennlinie G) ergibt sich D1. Um dieses fehlerfreie Ausgangssignal zu erhalten, muß dem Leistungsverstärker 4 demnach ein korrigiertes Signal C1′ vorgegeben werden. Die Differenz zwischen C1′ und C1 ist als Korrekturwert Δ C1 bezeichnet. Für unterschiedliche Signale C ergeben sich unterschiedliche Korrekturwerte ΔC. die Zuordnung zwischen den Signalen C und den Korrekturwerten Δ C ist in der Fehlerkorrekturschaltung 3 abgespeichert.

In Fig. 4 ist das Ausgangssignal C der Fehlerkorrekturschaltung 3 in Abhängigkeit des eingangsseitig an ihr liegenden Signals dargestellt. Das eingangs an der Fehlerkorrekturschaltung 3 liegende Signal entspricht dem Ausgangssignal B des Meßwertumformers 2. Die Kennlinie der Fehlerkorrekturschaltung 3 ist mit I bezeichnet. Diese Kennlinie I berücksichtigt sowohl die gemäß Fig. 2 im Meßwertumformer 2 auftretenden Fehler durch Vorgabe von Korrekturwerten ΔB als auch die gemäß Fig. 3 im Leistungsverstärker 4 auftretenden Fehler durch Vorgabe von Korrekturwerten ΔC, d.h. beide Korrekturwerte ΔB, ΔC sind in die gemeinsame Kennlinie I eingearbeitet. Somit gibt die Fehlerkorrekturschaltung 3 bei Vorgabe eines fehlerbehafteten Signales B1′ ein entsprechend korrigiertes Signal C1′ an den Leistungsverstärker 4 ab. Dabei ist zu beachten, daß das fehlerbehaftete Signal B1′ durch den Meßwertumformer 2 aus der Meßgröße A1 gebildet wird (siehe Fig. 2, Kennlinie F) und daß das korrigierte Signal C1′ durch den Leistungsverstärker 4 in ein Signal D1 umgeformt wird (siehe Fig. 3, Kennlinie H). Letztendlich wird damit durch die Fehlerkorrekturschaltung 3 bewirkt, daß eine Meßgröße A trotz des Einsatzes eines fehlerbehafteten Meßwertumformers 2 und eines fehlerbehafteten Leistungsverstärkers 4 in ein fehlerfreies Signal D umgewandelt wird, d.h. in der Fehlerkorrekturschaltung werden die jeweilige Nichtlinearität des Meßwertumformers 2 sowie des Leistungsverstärkers 4 kompensiert.

Die Fehlerkorrekturschaltung 3 des Wandlers 1 läßt sich vorteilhaft als Mikrorechner aufbauen, wobei die den Fehler des Meßwertumformers 2 und die Nichtlinearität des Verstärkers 4 kennzeichnenden und für ihre Korrektur notwendigen Daten, beispielsweise innerhalb eines EPROMs (erasable programmable read only memory) gespeichert werden können.

Die den Fehler des Meßwertumformers 2 und die Nichtlinearität des Verstärkers 4 kennzeichnenden und für ihre Korrektur notwendigen Daten können für jeden Wandler 1 individuell in einer Prüfschaltung ermittelt werden (Fingerabdruck des Wandlers), so daß Fertigungstoleranzen keinen Einfluß auf die Genauigkeit des Wandlers haben. Hierzu wird der zu prüfende Wandler 1 eingangsseitig mit Prüfsignalen beaufschlagt und die real ausgangsseitig abgegebenen Signale werden mit idealen, fehlerfreien Signalen verglichen. Je nach Differenz zwischen realem und idealem Signal werden die zur Korrektur notwendigen Daten der Fehlerkorrekturschaltung 3 eingegeben.

Der beschriebene Aufbau eines Wandlers 1 kann vorteilhaft auch angewandt werden, indem einem vorhandenen Wandler geringer Güte und geringer Ausgangsleistung die Fehlerkorrekturschaltung 3 und der Leistungsverstärker 4 nachgeschaltet werden, wodurch ein Wandler höherer Güte und höherer Ausgangleistung entsteht ("upgrading").

**Patentansprüche**

1. Elektrischer Wandler für die Messung von Strom oder Spannung in Anlagen der elektrischen Energieverteilung und Energieübertragung, unter Einsatz eines als Strom- oder Spannungswandler ausgebildeten Meßwertumformers (2), eines Leistungsverstärkers (4) und einer elektronischen Fehlerkorrekturschaltung (3), die der Fehlerkennlinie des Meßwertumformers (2) angepaßt ist, indem die den Fehler des Meßwertumformers (2) kennzeichnenden und für seine Korrektur notwendigen Daten innerhalb der Fehlerkorrekturschaltung (3) gespeichert sind, dadurch gekennzeichnet, daß der Meßwertumformer (2), die elektronische Fehlerkorrekturschaltung (3) und der Leistungsverstärker (4) in der gennanten Reihenfolge hintereinandergeschaltet sind, und daß die Fehlerkorrekturschaltung (3) zusätzlich der Nichtlinearität des Leistungsverstärkers (4) angepaßt ist, indem auch die die Nichtlinearität des Leistungsverstärkers (4) kennzeichnenden und für ihre Korrektur notwendigen Daten innerhalb der Fehlerkorrekturschaltung (3) gespeichert sind.

2. Elektrischer Wandler nach Anspruch 1, gekennzeichnet durch den Einsatz eines EPROM-Speichers für die Speicherung der Daten.

3. Elektrischer Wandler nach einem der Ansprüche 1 und 2, gekennzeichnet durch den Aufbau der Fehlerkorrekturschaltung (3) als Mikrorechner.

4. Verfahren zur Einstellung des elektrischen Wandlers mit einer Hintereinanderschaltung eines Meßwertumformers (2), einer elektronischen Fehlerkorrekturschaltung (3) und eines Leistungsverstärkers (4) nach einem der Ansprüche 1 bis 3, dadurch gekennzeichnet, daß die den Fehler des Meßwertumformers (2) und die Nichtlinearität des Leistungsverstärkers (4) kennzeichnenden und für ihre Korrektur notwendigen Daten für jeden Wandler individuell in einer Prüfschaltung ermittelt und der Fehlerkorrekturschaltung (3) eingegeben werden.

**Claims**

1. Electrical transformer for measuring current or voltage in installations for electrical energy distribution and energy transmission, using a measurement value transducer (2) constructed as a current or voltage transformer, a power amplifier (4) and an electronic error correction circuit (3) which matches the error characteristic of the measurement value transducer (2), in that the data characterising the error of the measurement value transducer (2) and necessary for its correction are stored within the error correction circuit (3), characterised in that the measurement value transducer (2), the electronic error correction circuit (3) and the power amplifier (4) are connected in series with one another in the said order, and in that the error correction circuit (3) is additionally matched to the non-linearity of the power amplifier (4), in that the data characterising the non-linearity of the power amplifier (4) and necessary for its correction are also stored within the error correction circuit (3).

2. Electrical transformer according to Claim 1, characterised by the use of an EPROM memory for storing the data.

3. Electrical transformer according to one of Claims 1 and 2, characterised by the error correction circuit (3) being constructed as a microprocessor.

4. Method for adjusting the electrical transformer, comprising a series circuit of a measurement value transducer (2), an electronic error correction circuit (3) and a power amplifier (4) in accordance with one of Claims 1 to 3, characterised in that the data characterising the error of the measurement value transducer (2) and the non-linearity of the power amplifier (4), and necessary for their correction, are determined individually for each transformer in a test circuit and are input to the error correction circuit (3).

**Revendications**

1. Transformateur électrique pour la mesure du courant ou de la tension dans des installations pour la distribution et le transport d'énergie électrique utilisant un transformateur de mesure (2) agencé en transformateur d'intensité ou en transformateur de tension, un amplificateur de puissance (4) et un circuit électronique de correction d'erreur (3) qui est adapté à la courbe caractéristique d'erreur du transformateur de mesure (2) par le fait que les données caractérisant l'erreur du transformateur de mesure (2) et les données nécessaires à sa correction sont stockées dans le circuit de correction d'erreur (3), caractérisé en ce que le transformateur de mesure (2), le circuit électronique de correction d'erreur (3) et l'amplificateur de puissance (4) sont montés l'un à la suite de l'autre dans l'ordre indiqué, et en ce que le circuit de correction d'erreur (3) est en outre adapté à la non-linéarité de l'amplificateur de puissance (4) par le fait que les données caractérisant la non-linéarité de l'amplificateur de puissance (4) et les données nécessaires à sa correction sont également stockées à l'intérieur du circuit de correction d'erreur (3).

2. Transformateur électrique selon la revendication 1, caractérisé en ce qu'on utilise une mémoire EPROM pour le stockage des données.

3. Transformateur électrique selon la revendication 1, caractérisé en ce que le circuit de correction d'erreur (3) se présente sous la forme d'un micro-calculateur.

4. Procédé pour le réglage du transformateur électrique comportant, branchés l'un à la suite de l'autre, un transformateur de mesure (2), un circuit électronique de correction d'erreur (3) et un amplificateur de puissance (4) selon l'une des revendications 1 à 3, caractérisé en ce qu'on détermine dans un circuit de contrôle, individuellement pour chaque transformateur, les données caractérisant l'erreur du transformateur de mesure (2) et la non-linéarité de l'amplificateur de puissance (4) et les données nécessaires à leur correction et on les introduit dans le circuit de correction d'erreur (3).

Fig.1

Fig.2

Fig.3

Fig.4